# EUROPÄISCHE PATENTSCHRIFT

(11) **EP 2 238 817 B1**
(45) Veröffentlichungstag und Bekanntmachung des Hinweises auf die Patenterteilung: **29.06.2011**
(21) Anmeldenummer: 08872131.1
(22) Anmeldetag: 13.10.2008
(51) Int. Cl.: H05K 7/20, H05K 7/14

(54) **UMRICHTERMOTOR**
INVERTER MOTOR
MOTEUR À CONVERTISSEUR

(30) Priorität: 07.02.2008 DE 102008007825
(43) Veröffentlichungstag der Anmeldung: 13.10.2010
(73) Patentinhaber: Siemens Aktiengesellschaft, 80333 München (DE)
(72) Erfinder: BILLMANN, Markus, 91448 Emskirchen (DE); DOMES, Konrad, 09112 Chemnitz (DE); HEINING, Hans-Dieter, 97616 Bad Neustadt (DE); SCHIERLING, Hubert, 91052 Erlangen (DE); SCHMIDT, Richard, 91083 Baiersdorf (DE); WINDISCHMANN, Heinrich, 91315 Höchstadt (DE)
(86) Internationale Anmeldenummer: PCT/EP2008/063695
(87) Internationale Veröffentlichungsnummer: WO 2009/097916

(56) Entgegenhaltungen:
- EP-A- 0 825 703
- EP-A- 1 184 905
- DE-A1- 10 127 169
- DE-A1-102005 032 971
- JP-A- 2003 218 567

## Beschreibung

Die Erfindung bezieht sich auf einen Umrichtermotor gemäß Oberbegriff des Anspruchs 1.

Die Integration eines Umrichters, insbesondere eines Frequenzumrichters, in einem Motor ist ein wesentliches Merkmal der dezentralen Antriebstechnik. Wegen des Platzbedarfs und der Forderung nach Kompaktheit sowie des Kostendrucks ist dabei gefordert, möglichst wenig oder preisgünstiger Aufbautechniken zu generieren. Bei im Handel erhältlichen Umrichtermotoren wird entweder die axiale oder die radiale Aufbauweise umgesetzt. Dabei wird die Geometrie des Motors nicht speziell auf die Anforderungen angepasst. Es werden in der Regel Motoren aus dem Standardsortiment des jeweiligen Herstellers verwendet.

Aus der DE 10 2005 032 971 A1 ist ein Umrichtermotor bekannt, dessen Umrichtergehäuse axial am B-seitigen Lagerschild des Rotors befestigt ist. Die Bauelemente einer Umrichterelektronik sind auf mehrere Leiterplatten verteilt angeordnet, die mittels flexibler elektrischer Verbindungselementen einen Leiterstrang bilden. Die Leiterplatten dieses Leiterplattenstranges sind derart gegeneinander abgekantet, dass dieser Leiterplattenstrang eine Mantelfläche eines quaderförmigen Hohlzylinders bildet, deren Achse radial zur Achse des Motors im Umrichtergehäuse angeordnet ist. Bei dieser Einbaulage des quaderförmigen Hohlzylinders sind die verlustbehafteten Bauelemente der Umrichterelektronik thermisch leitend mit dem B-seitigen Lagerschild des Motors verbunden. Bei dieser Einbaulage wird die Entwärmung der verlustbehafteten Bauelemente mittels des B-seitigen Lagerschildes, des Motorgehäuses und des A-seitigen Lagerschildes bewerkstelligt. Um die Entwärmung des Innenraums des Umrichtergehäuses zu verbessern, bestehen die Umrichter-Gehäusewandungen und der Umrichter-Gehäusedeckel aus einem wärmeleitenden Material. Soll die Entwärmung noch weiter verbessert werden, so ist der Umrichter-Gehäusedeckel als Kühlkörper ausgebildet. In diesem Fall ist der quaderförmige Hohlzylinder derart im Umrichtergehäuse angeordnet, dass die verlustbehafteten Bauelemente der Umrichterelektronik thermisch leitend mit dem als Kühlkörper ausgebildeten Umrichter-Gehäusedeckel verbunden sind. Als Motor wird bevorzugt ein permanent erregter Synchronmotor verwendet. Ein derartiger Synchronmotor weist gegenüber einem leistungsgleichen Asynchronmotor eine geringere Verlustleistung auf. Außerdem weist dieser Synchronmotor gegenüber einem leistungsgleichen Asynchronmotor eine geringere Baugröße auf.

Einen gattungsgemäß Umrichtermotor ist aus dem Prospekt mit dem Titel "TorqueWire servo systems" der Firma PHASE Motion Control, bekannt. Bei diesem Umrichtermotor sind die Bauelemente der Umrichterelektronik auf beiden Seiten einer Leiterplatte angeordnet, wobei die verlustbehafteten Bauelemente derart angeordnet sind, dass diese thermisch leitend mit einem als Kühlkörper ausgebildeten Umrichter-Gehäusedeckel verbunden sind. Die Verlustleistung der verlustbehafteten Bauelemente der Umrichterelektronik erfolgt durch Konvektionskühlung. Die Umrichter-Gehäusewandungen, die eine quadratische Fläche umspannen, sind aus einem thermisch isolierenden Material. Dadurch sind die beiden Wärmequellen, nämlich der Motor und das Leistungsteil des Umrichters, voneinander entkoppelt. Diese Umrichter-Gehäusewandungen nehmen im umfassenden Raum die Umrichterelektronik auf. Da der als Kühlkörper ausgebildete Umrichter-Gehäusedeckel aus einem metallischen Material besteht, müssen die verlustbehafteten Bauelemente elektrisch isolierend mit diesem Kühlkörper verbunden sein. Durch diese elektrisch isolierende und thermische leitende Zwischenschicht wird der Wärmeübergang zum Kühlkörper beeinträchtigt.

Der Erfindung liegt nun die Aufgabe zugrunde, einen gattungsgemäßen Umrichtermotor derart weiterzubilden, dass dessen Nachteile nicht mehr auftreten.

Diese Aufgabe wird erfindungsgemäß mit den Merkmalen des Anspruchs 1 gelöst.

Erfindungsgemäß wird die Leiterplatte der Umrichterelektronik in mehrere Leiterplattensegmente unterteilt, die derart gegeneinander abgekantet sind, dass ein Hohlraum entsteht, in dem die Bauelemente der Umrichterelektronik Platz finden. Dabei sind diese Bauelemente derart auf die einzelnen Leiterplattensegmente verteilt angeordnet, das die Bauelemente jeweils mit einer geringen Verlustleistung jeweils mit einer Wand einer Umrichter-Gehäusewandung thermisch leitend verbunden sind. Außerdem sind die verlustbehafteten Bauelemente flächig auf dem Leiterplattensegment angeordnet, das dem Kühlkörper, der aus einem thermisch leitenden Kunststoff besteht, zugeordnet ist. Bauelemente der Umrichterelektronik, die thermisch unkritisch sind, sind auf Leiterplattensegmenten untergebracht, die sich nach der Faltung der Leiterplatte im Inneren eines entstandenen Hohlraums befinden. Damit die Bauelemente der Umrichterelektronik nicht von der Wärmestrahlung des Motors beaufschlagt werden, ist dieser Motor B-seitig mit einer Schottwand aus thermisch isolierenden Material versehen, auf der eine Steckerleiste angeordnet ist, mit der durch stecken des Umrichter-Gehäuses axial auf die B-Seite des Motors die Umrichterelektronik mit dem Motor elektrisch leitend verbunden ist.

Durch die räumlich verteilte Anordnung der verlustleistungserzeugenden Bauelemente der Umrichterelektronik über die gesamte Fläche eines Leiterplattensegmentes, das thermisch leitend mit dem Kunststoff-Kühlkörper verbunden ist, wird ein geometrischer Wärme-Spreiz-Effekt bewirkt, wodurch die gesamte Fläche des Kühlkörpers an der Entwärmung beteiligt wird. Da der Kühlkörper aus einem thermisch leitenden aber elektrisch isolierenden Material besteht, muss das Leiterplattensegment mit den verlustleistungserzeugenden Bauelemente nicht mehr elektrisch isoliert werden, wodurch der Wärmeübergang zwischen Leiterplattensegment zum Kühlkörper nicht mehr beeinträchtigt wird.

Bei einer vorteilhaften Ausführungsform des Umrichtermotors sind die Wände der Umrichter-Gehäusewandung mit radial verlaufenden Kühlrippen versehen, die axial zueinander beabstandet sind. Dadurch wird der Wärmeübergang an die Umgebungsluft verbessert, wodurch einerseits die Entwärmung der Umrichterelektronik und andererseits die thermische Entkopplung von Motor und Umrichterelektronik sich verbessern.

Bei einer weiteren vorteilhaften Ausgestaltung des Umrichtermotors ist der Kühlkörper aus thermisch leitenden und elektrisch isolierenden Material direkt auf die der verlustbehafteten Bauelemente der Umrichterelektronik abgewandte Seite des Leiterplattensegmentes gespritzt. Dadurch erhöht sich die thermische Anbindung dieses Leiterplattensegmentes erheblich.

Bei einer weiteren vorteilhaften Ausgestaltung des Umrichtermotors ist die abgekantete mehrere Leiterplattensegmente aufweisende Leiterplatte der Umrichterelektronik im Umrichter-Gehäuse vergossen. Mittels diesem Verguss ist die Umrichterelektronik gegen Erschütterungen und/oder Vibrationen ausreichend geschützt.

Um die Verlustleistung des Umrichtermotors möglichst gering zu halten, ist bei einer weiteren vorteilhaften Ausgestaltung dieses Umrichtermotors als Motor ein permanent erregter Synchronmotor, insbesondere ein Synchronmotor in Oberwellentechnik, vorgesehen. Gegenüber einem leistungsgleichen Asynchronmotor ist dieser permanent erregte Synchronmotor verlustärmer. Gleichzeitig beansprucht ein derartiger Synchronmotor gegenüber einem leistungsgleichen Asynchronmotor einen geringeren Bauraum, so dass der Platzbedarf eines Umrichtermotors mit permanent erregtem Synchronmotor geringer ist.

Zur weiteren Erläuterung der Erfindung wird auf die Zeichnung Bezug genommen, in der ein Umrichtermotor nach der Erfindung schematisch veranschaulicht ist.
- FIG 1: zeigt eine Prinzipdarstellung des Umrichtermotors nach der Erfindung, in der
- FIG 2: ist der Blick ins Innere einer Umrichterelektronik in einem Umrichter-Gehäuse des Umrichtermotors nach FIG 1 dargestellt, die
- FIG 3: zeigt eine Seitenansicht eines Motors mit ange- flanschten Umrichter-Gehäuse des Umrichtermotors nach FIG 1, in der
- FIG 4: ist die Sicht auf eine B-seitige Schottwand des Mo- tors des Umrichtermotors nach FIG 1 dargestellt, die
- FIG 5: zeigt ein zentrales Leiterplattensegment in der Um- richter-Gehäusewandung des Umrichtermotors nach FIG 1 und die
- FIG 6: zeigt eine Sicht auf die Bestückungsseite einer in mehrere Leiterplattensegmente unterteilten Leiter- platte einer Umrichterelektronik eines Umrichtermo- tors nach FIG 1, wogegen in der
- FIG 7: die Leiterplatte nach FIG 6 nach der Faltung darge- stellt ist.

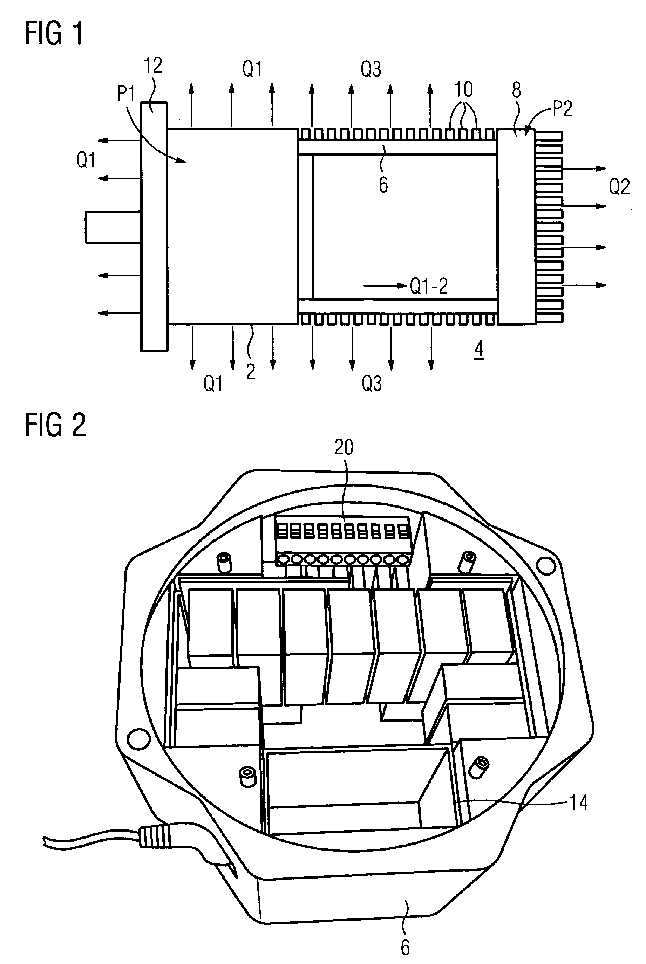

In der Prinzipdarstellung nach FIG 1 sind mit 2 ein Motor, insbesondere ein permanent erregter Synchronmotor, und mit 4 ein Umrichter bezeichnet. Der Umrichter 4 ist zweigeteilt ausgeführt. Der eine Teil ist die Umrichter-Gehäusewandung 6 und der zweite Teil ist der als Deckel ausgebildete Kühlkörper 8. In dieser Darstellung ist die Umrichter-Gehäusewandung 6 mit axial beabstandeten axial verlaufenden Kühlrippen 10 versehen. Bei einem Umrichtermotor bilden der Motor 2 und die Leistungselektronik des Umrichters 4 jeweils eine Haupt-Wärmequelle P1 und P2. Da die verlustleistungserzeugenden Bauelemente der Umrichterelektronik (Leistungselektronik) indirekt thermisch mit dem Kühlkörper 8 verbunden sind, ist die Haupt-Wärmequelle P2 der Kühlkörper 8, der die Verlustleistung abführt. Diese beiden Haupt-Wärmequellen P1 und P2 sind durch die Umrichter-Gehäusewandung 6 aus einem thermisch isolierenden Material thermisch entkoppelt. Diese Entkopplung bewirkt, dass ein Wärmefluss Q1 nur über einen Motorflansch 12 des Motors 2 und über die Oberfläche dieses Motors 2 an eine Umgebung abgegeben wird. Ein Wärmefluss Q2 der Leistungselektronik wird über den Kühlkörper 8 mittels natürlicher Konvektion an eine Umgebungsluft abgegeben. Ein Wärmefluss Q3 einer dritten Wärmequelle P3, nämlich eine Signalelektronik der Umrichterelektronik, wird über die Umrichter-Gehäusewandung 6, deren Oberflächen mittels einer Anzahl von Kühlrippen 10 vergrößert ist, an eine Umgebungsluft abgegeben. Trotz des thermischen Widerstandes des thermisch isolierenden Materials der Umrichter-Gehäusewandung 6 findet wegen der relativ großen Fläche dieser Umrichter-Gehäusewandung 6 ein hinreichend guter Wärmefluss Q3 zur Umgebung statt. Zwischen diesen beiden Wärmequellen P1 und P2 findet praktisch kein Wärmefluss Q1-2 statt, da die Querschnittsfläche der Umrichter-Gehäusewandung 6 relativ klein ist und der Wärmefahrt parallel zur Umrichter-Gehäusewandung 6 lang ist.

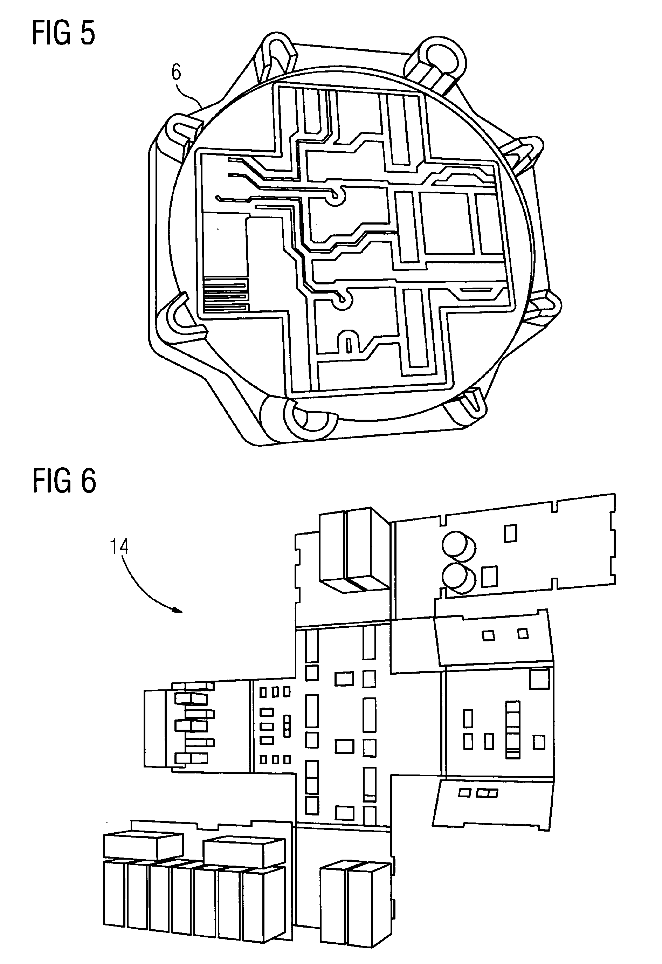

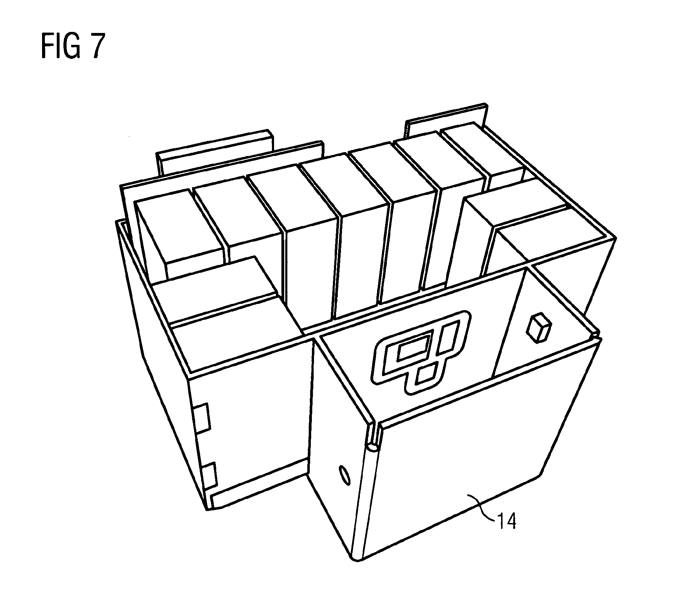

Die FIG 2 zeigt einen Blick ins Innere der Umrichterelektronik eines Umrichtermotors nach der Prinzipdarstellung gemäß FIG 1. In dieser Darstellung ist die Umrichter-Gehäusewandung 6 und eine gefaltete Leiterplatte 14 der Umrichterelektronik zu sehen. Diese gefaltete Leiterplatte 14 ist ohne die Umrichter-Gehäusewandung 6 in der FIG 7 näher dargestellt, wobei die bestückte Leiterplatte 14 vor der Faltung in der FIG 6 dargestellt ist. Diese gefaltete Leiterplatte 14 bildet einen Hohlraum, die Bauelemente der Umrichterelektronik aufnimmt. Dabei sind die Bauelemente der Umrichterelektronik, die entweder auf niedrigem Temperaturniveau gehalten werden müssen, beispielsweise ein Mikroprozessor, oder in nur geringen Maßen eigene Verluste erzeugen, auf Leiterplattensegmente dieser Leiterplatte 14 angeordnet, die unmittelbar flächigen Kontakte mit den Wänden der aus einem thermisch isolierenden Material hergestellten Umrichter-Gehäusewandung 6 entwärmt werden. Bauelemente der Umrichterelektronik, die thermisch unkritisch sind, sind auf Leiterplattensegmenten der Leiterplatte 14 angeordnet, die sich nach der Faltung der Leiterplattensegmente der Leiterplatte 14 im Inneren eines gebildeten Hohlraums befinden. Durch eine derartige Verteilung der Bauelemente der Signalelektronik der Umrichterelektronik auf vorbestimmte Leiterplattensegmente der Leiterplatte 14 wird das zur Verfügung stehende Bauvolumen hoch ausgenutzt.

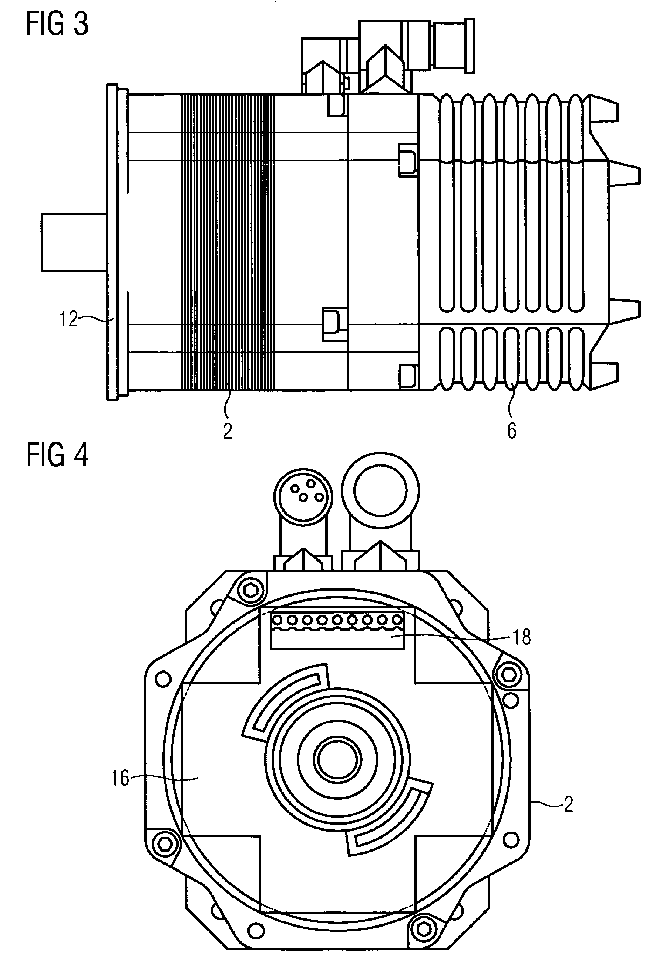

Die Seitenansicht des Umrichtermotors gemäß FIG 3 zeigt den Motor 2, insbesondere einen permanent erregten Synchronmotor, und die Umrichter-Gehäusewandung 6 des Umrichters 4, der an der B-Seite des Motors 2 angeflanscht ist.

In der FIG 4 ist die Sicht auf die B-Seite des Motors 2 dargestellt. Diese B-Seite ist mit einer Schottwand 16 aus thermisch isolierendem Material verschlossen. Dadurch ist der von der gefalteten Leiterplatte 14 gebildete Innenraum der Umrichterelektronik von der Wärmestrahlung des Motors 2 thermisch abgeschottet. Zur elektrischen Kontaktierung des Umrichters 4 mit dem Motor 2 weist diese thermische Schottwand 16 eine Steckerleiste 18 auf, deren Gegenstück 20 in der FIG 2 zu sehen ist. Beim Anflanschen der bestückten Umrichter-Gehäusewandung 6 an die B-Seite des Motors 2 greifen die Steckerleiste 18 und sein Gegenstück 20 ineinander, wodurch Ausgangsanschlüsse des Umrichters 4 mit Klemmenanschlüssen des Motors 2 elektrisch leitend verbunden werden.

Die FIG 5 zeigt eine Sicht auf die Lötseite des zentrales Leiterplattensegmentes der Leiterplatte 14, das verlusterzeugende Bauelemente der Leistungselektronik der Umrichterelektronik aufweist. D.h., diese Sicht zeigt die Rückseite der gefalteten Leiterplatte 14 in der Umrichter-Gehäusewandung 6 gemäß FIG 2. Die Bauelemente der Leistungselektronik der Umrichterelektronik sind auf der abgewandten Seite (Bauelementeseite) dieses zentralen Leiterplattensegmentes angeordnet. Auf diese Seite dieses zentralen Leiterplattensegmentes wird der Kunststoff-Kühlkörper 8 direkt geklebt. Besonders vorteilhaft ist es, wenn dieser Kunststoff-Kühlkörper 8 direkt auf der Lötseite des verlustleistungserzeugende Bauelemente der Leistungselektronik der Umrichterelektronik aufweisenden zentralen Leiterplattensegmentes gespritzt ist. Dadurch verbessert sich der Wärmeübergang zwischen den verlusterzeugenden Bauelementen und des Kunststoff-Kühlkörpers 8 wesentlich. Dieser Kunststoff-Kühlkörper 8 ist beispielsweise mit dieser Umrichter-Gehäusewandung 6 lösbar befestigt.

Wie bereits erwähnt, zeigt die FIG 6 die Leiterplatte 14 mit seinen bestückten Leiterplattensegmenten. Die zugehörige gefaltete Leiterplatte 14 ist in der FIG 7 näher dargestellt. Von dieser gefalteten Leiterplatte 14 sind die Außenwände des gebildeten Hohlraums zu erkennen, die nach dem Einsetzen in die Umrichter-Gehäusewandung 6 im flächigen Kontakt mit den Innenseiten der Wände der Umrichter-Gehäusewandung 6 stehen. Die Gestaltung der faltbaren Leiterplatte 14 in Form einer dreidimensionalen Schaltungsanordnung ist nach thermodynamischen Gesichtspunkten ausgelegt. Dabei ist das Leiterplattensegment mit den flächig verteilten Leistungselektronik-Bauelementen dem Gehäuseteil des Umrichtergehäuses mit dem wärmeleitenden Kusntstoff-Kühlkörper 8 zugeordnet. Schaltungsteile mit Bauelementen der Signalelektronik der Umrichterelektronik, die entweder auf niedrigen Temperaturniveau gehalten werden müssen oder in nur geringem Maße eine Verlustleistung erzeugen, sind auf Leiterplattensegmenten der Leiterplatte 14 angeordnet, die durch unmittelbaren flächigen Kontakt mit Wänden der aus thermisch isolierendem Material hergestellten Umrichter-Gehäusewandung 6 entwärmt werden. Bauelemente der Signalelektronik der Umrichterelektronik, die thermisch unkritisch sind, sind auf Leiterplattensegmenten der Leiterplatte 14 angeordnet, die sich nach der Faltung der Leiterplatte 14 im Inneren des entstandenen Hohlraums wiederfinden.

Dieser gebildete Hohlraum mit den in diesem Hohlraum ragenden Bauelementen der Signal- und Leistungselektronik der Umrichterelektronik kann mit einer Vergussmasse ausgegossen werden, wenn dieser Umrichtermotor bei einem Antriebssystem verwendet wird, das Erschütterungen und/oder Vibrationen ausgesetzt ist.

Durch die erfindungsgemäße Ausbildung des Umrichters eines Umrichtermotors erhält man einen kompakten lüfterlosen Umrichtermotor, der hinsichtlich der Entwärmung und des mechanischen Aufbaus optimiert worden ist.

## Patentansprüche

1. Umrichtermotor, umfassend einen Motor (2) und einen Umrichter (4), wobei Bauelemente einer Umrichterelektronik auf einer Leiterplatte (14) derart angeordnet sind, dass verlustbehaftete Bauelemente mit einem als Deckel eines Umrichter-Gehäuses aus thermisch isolierenden Kunststoff ausgebildeten Kühlkörper (8) thermisch leitend verbunden sind, wobei dieses Umrichter-Gehäuse aus thermisch isolierenden Kunststoff axial an einer B-Seite des Motors (2) befestigt ist, **dadurch gekennzeichnet, dass** die Leiterplatte (14) in mehrere Leiterplattensegmente unterteilt ist, die derart gegeneinander abgekantet sind, dass Leiterplattensegmente mit Bauelementen mit geringer Verlustleistung jeweils mit einer Wand einer Umrichter-Gehäusewandung (6) thermisch leitend verbunden sind und dass ein zentrales Leiterplattensegment mit verlusterzeugenden Bauelementen mit einen aus thermisch leitenden Kunststoff bestehenden Kühlkörper (8) thermisch leitend verbunden ist, und dass der Motor (2) B-seitig mit einer Schottwand (16) aus thermisch isolierenden Material versehen ist, auf der eine Steckerleiste (18) angeordnet ist.

2. Umrichtermotor nach Anspruch 1, **dadurch gekennzeichnet, dass** jede Wand der Umrichter-Gehäusewandung (6) mit radial verlaufenden Kühlrippen (10) versehen sind.

3. Umrichtermotor nach Anspruch 1 oder 2, **dadurch gekennzeichnet, dass** der Kühlkörper (8) aus thermisch leitenden Kunststoff auf einer Seite des zentralen Leiterplattensegmentes, die der Seite mit verlustbehafteten Bauelementen abgewandt ist, thermisch leitend geklebt ist.

4. Umrichtermotor nach Anspruch 1 oder 2, **dadurch gekennzeichnet, dass** der Kühlkörper (8) aus thermisch leitenden Kunststoff auf einer Seite des zentralen Leiterplattensegmentes, die der Seite mit verlustbehafteten Bauelementen abgewandt ist, gespritzt ist.

5. Umrichtermotor nach einem der vorgenannten Ansprüche, **dadurch gekennzeichnet, dass** die aus mehreren Leiterplattensegmenten bestehende Leiterplatte (14) im Umrichter-Gehäuse vergossen ist.

6. Umrichtermotor nach einem der vorgenannten Ansprüche, **dadurch gekennzeichnet, dass** als Motor (2) ein permanent erregter Synchronmotor vorgesehen ist.

7. Umrichtermotor nach Anspruch 5, **dadurch gekennzeichnet, dass** als Vergussmasse ein thermisch leitender Kunststoff vorgesehen ist.

8. Umrichtermotor nach Anspruch 5, **dadurch gekennzeichnet, dass** als Vergussmasse ein thermisch isolierender Kunststoff vorgesehen ist.

## Claims

1. Converter motor, comprising a motor (2) and a converter (4), wherein components of converter electronics are arranged on a printed circuit board (14) such that lossy components are thermally conductively connected to a heat sink (8) which is in the form of a cover of a converter housing composed of thermally insulating plastic, wherein this converter housing composed of thermally insulating plastic is attached axially to a non-drive end of the motor (2), **characterized in that** the printed circuit board (14) is subdivided into a plurality of printed circuit board segments, which are angled with respect to one another such that printed circuit board segments with components with low power loss are each thermally conductively connected to one wall of a converter housing wall (6), and such that a central printed circuit board segment with components which produce losses is thermally conductively connected to a heat sink (8) which is composed of thermally conductive plastic, and **in that** the non-drive end of the motor (2) is provided with a partition wall (16) composed of thermally insulating material, on which a plug strip (18) is arranged.

2. Converter motor according to Claim 1, **characterized in that** each wall of the converter housing wall (6) is provided with radially running cooling ribs (10).

3. Converter motor according to Claim 1 or 2, **characterized in that** the heat sink (8) composed of thermally conductive plastic is thermally conductively adhesively bonded on a side of the central printed circuit board segment which faces away from the side with lossy components.

4. Converter motor according to Claim 1 or 2, **characterized in that** the heat sink (8) composed of thermally conductive plastic is molded on a side of the central printed circuit board segment which faces away from the side with lossy components.

5. Converter motor according to one of the abovementioned claims, **characterized in that** the printed circuit board (14) which comprises a plurality of printed circuit board segments is encapsulated in the converter housing.

6. Converter motor according to one of the abovementioned claims, **characterized in that** a permanent-magnet synchronous motor is provided as the motor (2).

7. Converter motor according to Claim 5, **characterized in that** a thermally conductive plastic is provided as the encapsulating compound.

8. Converter motor according to Claim 5, **characterized in that** a thermally insulating plastic is provided as the encapsulating compound.

## Revendications

1. Moteur à convertisseur, comprenant un moteur ( 2 ) et un convertisseur ( 4 ), des élements constitutifs d'une électronique de convertisseur étant disposés sur une plaquette ( 14 ) à circuits imprimés, de manière à ce que des composants, sujets à perte, soient reliés d'une manière conductrice thermiquement à un dissipateur ( 8 ) de chaleur constitué en couvercle d'un boîtier de convertisseur en matière plastique isolante thermiquement, ce boîtier de convertisseur en matière plastique isolante thermiquement étant fixé axialement sur un côté B du moteur ( 2 ), **caractérisé en ce que** la plaquette ( 14 ) à circuits imprimés est subdivisée en plusieurs segments de plaquette à circuits imprimés, qui sont chanfreinés les uns par rapport aux autres, de manière à ce que des segments de plaquette à circuits imprimés ayant des composants à petite puissance de perte soient reliés, d'une manière conductrice thermiquement, respectivement à une paroi ( 6 ) du boîtier de convertisseur et **en ce qu'**un segment central de plaquette à circuits imprimés, ayant des composants produisant des pertes, soit relié, d'une manière conductrice thermiquement, à un dissipateur ( 8 ) de chaleur en une matière conductrice thermiquement et **en ce que** le moteur ( 2 ) est pourvu du côté B d'une cloison ( 16 ) en matériau isolant thermiquement et sur laquelle est disposée une réglette ( 18 ) à fiche.

2. Moteur à convertisseur suivant la revendication 1, **caractérisé en ce que** chaque paroi du boîtier ( 6 ) de convertisseur est munie d'ailettes ( 10 ) de refroidissement s'étendant radialement.

3. Moteur à convertisseur suivant la revendication 1 ou 2, **caractérisé en ce que** le dissipateur ( 8 ) de chaleur, en matériau conducteur thermiquement, est collé d'une manière conductrice thermiquement d'un côté du segment central de la plaquette à circuits imprimés, qui est éloigné du côté ayant des composants sujets à perte.

4. Moteur à convertisseur suivant la revendication 1 ou 2, **caractérisé en ce que** le dissipateur ( 8 ) de chaleur, en matière plastique conductrice thermiquement, est injecté d'un côté du segment central de la plaquette à circuits imprimés, qui est éloigné du côté ayant des composants sujets à perte.

5. Moteur à convertisseur suivant l'une des revendications précédentes, **caractérisé en ce que** la plaquette ( 14) à circuits imprimés, constituée de plusieurs segments de plaquette à circuits imprimés, est scellée dans le boîtier du convertisseur.

6. Moteur à convertisseur suivant l'une des revendications précédentes, **caractérisé en ce qu'**il est prévu un moteur synchrone à excitation permanente comme moteur ( 2 ).

7. Moteur à convertisseur suivant la revendication 5, **caractérisé en ce qu'**il est prévu une matière plastique conductrice thermiquement comme composition de scellement.

8. Moteur à convertisseur suivant la revendication 5, **caractérisé en ce qu'**il est prévu une matière plastique isolante thermiquement comme composition de scellement.
